# EUROPÄISCHE PATENTSCHRIFT

(11) **EP 0 539 384 B1**
(45) Veröffentlichungstag und Bekanntmachung des Hinweises auf die Patenterteilung: **17.04.2002**
(21) Anmeldenummer: 91910289.7
(22) Anmeldetag: 04.06.1991
(51) Int. Cl.: H01L 23/544

(54) **VERFAHREN ZUM ANBRINGEN EINER DIE ORIENTIERUNG DES KRISTALLGITTERS EINER KRISTALLSCHEIBE ANGEBENDEN MARKIERUNG**
PROCESS FOR PRODUCING A MARKER INDICATING THE ORIENTATION OF THE CRYSTAL LATTICE OF A WAFER
PROCEDE D'APPLICATION D'UN MARQUAGE INDIQUANT L'ORIENTATION DU RESEAU CRISTALLIN D'UNE TRANCHE CRISTALLINE

(30) Priorität: 16.07.1990 DE 4022904
(43) Veröffentlichungstag der Anmeldung: 05.05.1993
(73) Patentinhaber: SIEMENS AKTIENGESELLSCHAFT, 80333 München (DE)
(72) Erfinder: STECKENBORN, Arno, D-1000 Berlin 20 (DE)
(86) Internationale Anmeldenummer: DE9100483
(87) Internationale Veröffentlichungsnummer: WO9202041

(56) Entgegenhaltungen:
- EP-A- 0 245 923
- WO-A-85/01349
- DE-A- 3 713 502
- PATENT ABSTRACTS OF JAPAN vol. 13, no. 429 (E-823)25. September 1989 & JP-A-1 158 747 (TOSHIBA CORP. ) 21. Juni 1989 siehe das ganze Dokument
- PATENT ABSTRACTS OF JAPAN vol. 11, no. 154 (E-508)19. Mai 1987 & JP-A-61 290 708 (FUJITSU LTD ) 20. Dezember 1986 siehe das ganze Dokument

## Beschreibung

In der Halbleiter-Prozeßtechnik, insbesondere in der Mikromechanik, tritt bei der Herstellung von dreidimensionalen Strukturen aus einkristallinem Halbleitermaterial das Problem auf, die Orientierung des Kristallgitters einer Kristallscheibe im Hinblick auf die Oberfläche der Kristallscheibe sehr genau kennen zu müssen. Werden nämlich aus derartigen Kristallscheiben durch Ätzen Strukturen herausgebildet, dann ist deren Maßgenauigkeit in hohem Maße von der Kristallorientierung abhängig; zum Herausätzen der Strukturen auf die Kristallscheiben aufzubringende Masken müssen dabei sehr genau zum Kristallgitter ausgerichtet sein. Je nach Größe bzw. Länge der herauszuätzenden Strukturen sind dabei hinsichtlich der Orientierung Winkelfehler von nur 0,01° zulässig.

In der Regel sind die aus einem größeren Halbleiter-Block durch Abrennen gebildeten Kristallscheiben so angelegt, daß ihre Oberfläche im wesentlichen mit der (100), (110) oder (111)-Ebene des Kristallgitters übereinstimmt. Wichtig für die Bearbeitung derartiger Kristallscheiben ist die Festlegung der (110)-Ebene. Dies geschieht dadurch, daß die Kristallscheiben mit einem sogenannten Flat, einer Abflachung am Umfang versehen werden. Diese Abflachung stellt eine Markierung für die Orientierung des Kristallgitters dar, da sie in der (110)-Ebene liegt. Allerdings läßt sich ein Flat nur mit einer Genauigkeit von ±0,3° bis ±1° in bezug auf die tatsächliche (110)-Ebene des Kristallgitters der Kristallscheibe herstellen; in Einzelfällen muß mit noch wesentlich größeren Abweichungen der Ausrichtung des Flats von der (110)-Ebene gerechnet werden. Ein Verfahren zum Herstellen eines Flat ist beispielsweise in "Patent Abstracts of Japan" Vol. 13, No. 429 (E-823), 25.09.1989 zur japanischen Offenlegungsschrift JP-A 1 158 747 beschrieben. Bei diesem Verfahren wird von der Kristallscheibe reflektierte Röntgenstrahlung von einem Detektor zur Feststellung der Orientierung des Kristallgitters erfaßt, und es werden eine Markierungseinrichtung und die Kristallscheibe derart zueinander in ihrer Ausrichtung verändert, daß die Markierungseinrichtung entsprechend der festgestellten Orientierung des Kristallgitters ausgerichtet ist; in der ausgerichteten Lage wird die Markierung an der Kristallscheibe angebracht.

Der Erfindung liegt die Aufgabe zugrunde, ein Verfahren zum Anbringen einer die Orientierung des Kristallgitters einer Kristallscheibe angebenden Markierung vorzuschlagen, mit dem sich eine in nur ganz geringem Umfang von der tatsächlichen Orientierung des Kristallgitters abweichende Markierung auf der Kristallscheibe anbringen läßt.

Zur Lösung dieser Aufgabe wird ausgehend von dem oben beschriebenen bekannten Verfahren erfindungsgemäß die Kristallscheibe in senkrechter Einfallrichtung mit der Röntgenstrahlung beaufschlagt und als Detektor eine Videokamera verwendet; in einem Rechner werden die elektrischen Ausgangssignale der Videokamera ausgewertet und durch ausgangsseitige Betätigungssignale des Rechners die Markierungseinrichtung und die Kristallscheibe zueinander ausgerichtet; als Markierungseinrichtung wird eine Einrichtung mit einem Markierungslaser und mit zwei Markierungselementen verwendet, die in fester räumlicher Anordnung zueinander gehalten sind, und in der ausgerichteten Lage wird auf einer Seite der Kristallscheibe die Markierung angebracht.

Es ist zwar aus der europäischen Patentanmeldung 0 245 923 A4 bekannt, mittels Röntgenstrahlung der Kristallorientierung zu ermitteln, jedoch geht es bei diesem Verfahren lediglich darum, eine Kristallprobe mit der äußeren Kontur einer Flasche so auszurichten, daß Kristallscheiben mit einer vorgegebenen Orientierung zum Kristallgitter aus der Probe geschnitten werden können.

Eine weitere Lösung der oben angegebenen Aufgabe besteht in einem Verfahren, bei dem in Fortbildung des eingangs beschriebenen bekannten Verfahrens erfindungsgemäß die Kristallscheibe in senkrechter Einfallrichtung an einer aufgerauten, kleinen Stelle mit der Strahlung eines Orientierungslasers beaufschlagt und als Detektor eine Videokamera verwendet wird; in einem Rechner werden die elektrischen Ausgangssignale der Videokamera ausgewertet und durch ausgangsseitige Betätigungssignale des Rechners die Markierungseinrichtung und die Kristallscheibe zueinander ausgerichtet; als Markierungseinrichtung eine Einrichtung wird mit einem Markierungslaser und mit zwei Markierungselementen verwendet wird, die in fester räumlicher Anordnung zueinander gehalten sind, und in der ausgerichteten Lage wird auf einer Seite der Kristallscheibe die Markierung angebracht.

Aus "Patent Abstracts of Japan", Vol. 11, No. 154, (E-508), 19.05.1987 zur japanischen Offenlegungsschrift JP-A-61 290 708 eine Markierung mit einem Laser auf eine Kristallscheibe anstelle eines Flat vorzusehen.

Ein wesentlicher Vorteil des erfindungsgemäßen Verfahrens besteht darin, daß mit ihm auf jede Kristallscheibe eine Markierung geschrieben werden kann, die mit großer Genauigkeit auf dem Kristall orientiert ist. Die Abweichung der Markierung von der tatsächlichen Kristallorientierung beträgt weniger als 1/100°. Dadurch ist die Möglichkeit gegeben, Ätzmasken mit ihren Rändern genau ausgerichtet zur Kristallorientierung auf die Kristallscheibe aufzubringen, so daß bei einem nachfolgenden Ätzvorgang sehr genau die Struktur herausgebildet wird, die durch die Maske vorgegeben ist.

Bei dem erfindungsgemäßen Verfahren kann ein und dieselbe Seite der Kristallscheibe mit der Röntgenstrahlung oder der Strahlung des Orientierungslasers beaufschlagt sowie mit der Markierung versehen werden. Es ist dabei lediglich auf eine entsprechende Führung der Strahlung sowie die Anordnung der Markierungseinrichtung zu achten, damit diesbezüglich keine gegenseitigen Behinderungen eintreten.

In dieser Hinsicht einfacher ist die Durchführung des Verfahrens dann, wenn eine Seite der Kristallscheibe mit der Röntgenstrahlung oder der Strahlung des Orientierungslasers beaufschlagt wird und auf die andere Seite der Kristallscheibe die Markierung aufgebracht wird. Allerdings ist bei dieser Ausführungsform des erfindungsgemäßen Verfahrens darauf zu achten, daß die zur Durchführung des erfindungsgemäßen Verfahrens benutzte Apparatur eine Zugänglichkeit zu beiden Seiten der Kristallscheibe ermöglicht.

Wird bei dem erfindungsgemäßen Verfahren mit Röntgenstrahlung gearbeitet, dann wird die Orientierung des Kristallgitters der zu untersuchenden Kristallscheibe über Röntgenbeugung gefunden, z. B. nach dem Laue-Verfahren. Eine Präparation der Kristallscheibe ist dazu nicht erforderlich.

Wird die zu untersuchende Kristallscheibe mit der Strahlung eines Orientierungslasers beaufschlagt, dann setzt dies eine aufgeraute, kleine Stelle auf der zu untersuchenden Kristallscheibe voraus. Diese aufgeraute, kleine Stelle kann vorteilhafterweise durch Ätzen mit einer Lauge, z. B. Kalilauge, erfolgen.

Um dabei nicht größere Stellen der Kristallscheibe zu beeinträchtigen, erfolgt in vorteilhafter Weise zur Begrenzung der kleinen Stelle lithografisch eine Ätzmaskierung, oder es wird ein nach außen abgedichteter Stempel mit innerer Zu- und Abführung der Lauge verwendet.

Als Markierungseinrichtung wird eine Einrichtung mit einem Markierungslaser verwende. Laser werden nämlich in aller Regel ohnehin eingesetzt, um Kristallscheiben mit einer Kennung zu versehen, damit die Scheiben später ohne weiteres wiedergefunden werden können.

Bei der Durchführung des erfindungsgemäßen Verfahrens wird sich in aller Regel ergeben, daß die Kristallscheibe hinsichtlich der Orientierung des Kristallgitters zum Flat nicht genau ausgerichtet ist. Dementsprechend ist bei der Durchführung des erfindungsgemäßen Verfahrens vor dem Anbringen der Markierung eine Ausrichtung von Kristallscheibe und Markierungseinrichtung zueinander erforderlich. In vorteilhafter Weise wird bei dem erfindungsgemäßen Verfahren die Ausrichtung von Markierungseinrichtung und Kristallscheibe zueinander durch Drehen der Kristallscheibe um eine senkrecht zu ihr verlaufende Achse vorgenommen.

Zur Durchführung des erfindungsgemäßen Verfahrens hat es sich ferner als vorteilhaft herausgestellt, wenn die Röntgenstrahlung oder die Strahlung des Orientierungslasers über einen halbdurchlässigen Spiegel der Kristallscheibe zugeführt wird und wenn die reflektierte Strahlung über denselben Spiegel der Videokamera zugeleitet wird. Dies ermöglicht einen relativ einfachen Aufbau der Anordnung zur Durchführung des Verfahrens.

Bei einer vorteilhaften Ausführungsform des erfindungsgemäßen Verfahrens wird von dem Rechner aus den Ausgangssignalen der Videokamera die Kristallgitter-Orientierung zur Oberflächennormale der Kristallscheibe (Azimut) bestimmt und zur doppelseitigen Bearbeitung der Kristallscheibe zu der Markierung auf der einen Seite der Kristallscheibe eine weitere Markierung auf der anderen Seite der Kristallscheibe derart aufgebracht, daß die weitere Markierung unter Berücksichtigung der Dicke der Kristallscheibe dem Azimut entsprechend versetzt ist. Mit diesem Verfahren ist es möglich, trotz Abweichung der Kristallscheiben-Oberflächenormale von einer vorgegebenen Kristallorientierung zu der ersten Markierung versetzt auf der gegenüberliegenden Seite der Kristallscheibe eine weitere Markierung aufzubringen, die für einen nachfolgenden Ätzvorgang einen derartigen Bearbeitungsvorhalt bewirkt, daß die Fehlorientierung kompensiert wird.

Der Erfindung liegt ferner die Aufgabe zugrunde, eine Anordnung vorzuschlagen, mit der sich eine die Orientierung des Kristallgitters einer Kristallscheibe sehr genau angebende Markierung auf der Kristallscheibe anbringen läßt.

Zur Lösung dieser Aufgabe dient erfindungsgemäß eine Anordnung zum Anbringen einer die Orientierung des Kristallgitters einer Kristallscheibe angebenden Markierung mit einer derart angeordneten Quelle für Röntgen- oder Laserstrahlung, daß eine senkrechte Einfallrichtung der Strahlung auf die Kristallscheibe ermöglicht ist, einer Halterung für die Kristallscheibe, einem Detektor in Form einer Videokamera zum Erfassen der von der Kristallscheibe reflektierten Strahlung, Mitteln zum Ausrichten der Kristallscheibe und einer Markierungseinrichtung gegeneinander, um in der ausgerichteten Lage Markierungen auf der Kristallscheibe anzubringen, wobei der Markierungseinrichtung einen Markierungslaser und zwei in fester räumlicher Zuordnung zueinander gehaltenen Markierungselemente umfaßt, und einem Rechner zum Auswerten der Steuersignale des Detektors und zum Steuern der Ausrichtung der Kristallscheibe und der Markierungseinrichtung gegeneinander.

Bei der erfindungsgemäßen Anordnung ist die Halterung für die Kristallscheibe vorteilhafterweise ein Drehmeßtisch, und die Markierungselemente der Markierungseinrichtung gegen über der vom Drehmeßtisch abgewandten Seite der Kristallscheibe angeordnet sind. In diesem Fall sind also die Markierungseinrichtungen bzw. deren Markierungselemente ortsfest angeordnet, und es muß nur die Kristallscheibe vom Drehmeßtisch gedreht werden, um vor der Anbringung der Markierung die Ausrichtung vornehmen zu können. Selbstverständlich kann gegebenenfalls auch die Kristallscheibe ortsfest gehalten sein, und es wird die Markierungseinrichtung in bezug auf die Kristallscheibe gedreht.

Bei der Anordnung zur Durchführung des erfindungsgemäßen Verfahrens kann auch die Markierungseinrichtung in verschiedener Weise ausgestaltet sein. Vorteilhaft erscheint es, bei einer Markierungseinrichtung mit einem Markierungslaser zwei Markierungselemente vorzusehen, die aus jeweils einer optischen Sammeleinrichtung bestehen; die Sammeleinrichtungen sind räumlich in fester Anordnung zueinander gehalten. Im einfachsten Falle besteht eine optische Sammeleinrichtung aus einer einzigen Sammellinse.

Bei der erfindungsgemäßen Anordnung können die optischen Sammeleinrichtungen in unterschiedlicher Weise mit dem Markierungslaser verbunden sein; als vorteilhaft wird es angesehen, den optischen Sammeleinrichtungen die Strahlung des Markierungslasers über jeweils einen Lichtleiter zuzuführen, weil in diesem Falle jede räumliche Kollision der Röntgenstrahlung bzw. der Strahlung des Orientierungslasers mit dem Weg zur Videokamera vermieden ist.

Kostruktiv einfacher im Vergleich dazu ist eine Ausführung der erfindungsgemäßen Anordnung, bei der den optischen Sammeleinrichtungen die Strahlung des Markierungslasers über fluchtend zum Ausgang des Markierungslasers angeordnete Umlenkspiegel zugeführt ist.

Bei einer Beaufschlagung der Kristallscheibe mit Röntgenstrahlung liegt bei der erfindungsgemäßen Anordnung vorteilhafter Weise zwischen dem halbdurchlässigen Spiegel und der Kristallscheibe ein Leuchtschirm, dessen Bild dann von der Videokamera erfaßt wird.

Zur Erläuterung der Erfindung sind in
- Figur 1: ein Ausführungsbeispiel eine Anordnung zur Durchführung des erfindungsgemäßen Verfahrens mit Bestrahlung der zu untersuchenden Kristallscheibe und Anbringung ihrer Markierung auf ein und derselben Seite, in
- Figur 2: ein weiteres Ausführungsbeispiel einer Anordnung zur Durchführung des erfindungsgemäßen Verfahrens mit Bestrahlung einer zu untersuchenden Kristallscheibe von einer Seite und Markierungsmöglichkeit von der anderen Seite, in
- Figur 3: ein zusätzliches Ausführungsbeispiel einer Anordnung zur Durchführung des erfindungsgemäßen Verfahrens mit Röntgenstrahlung, in
- Figur 4: ein Ausführungsbeispiel eines Stempels zur Erzeugung einer aufgerauhten, kleinen Stelle auf der Kristallscheibe und in
- Figur 5: zwei Laserstrahl-Reflexionsmuster dargestellt.

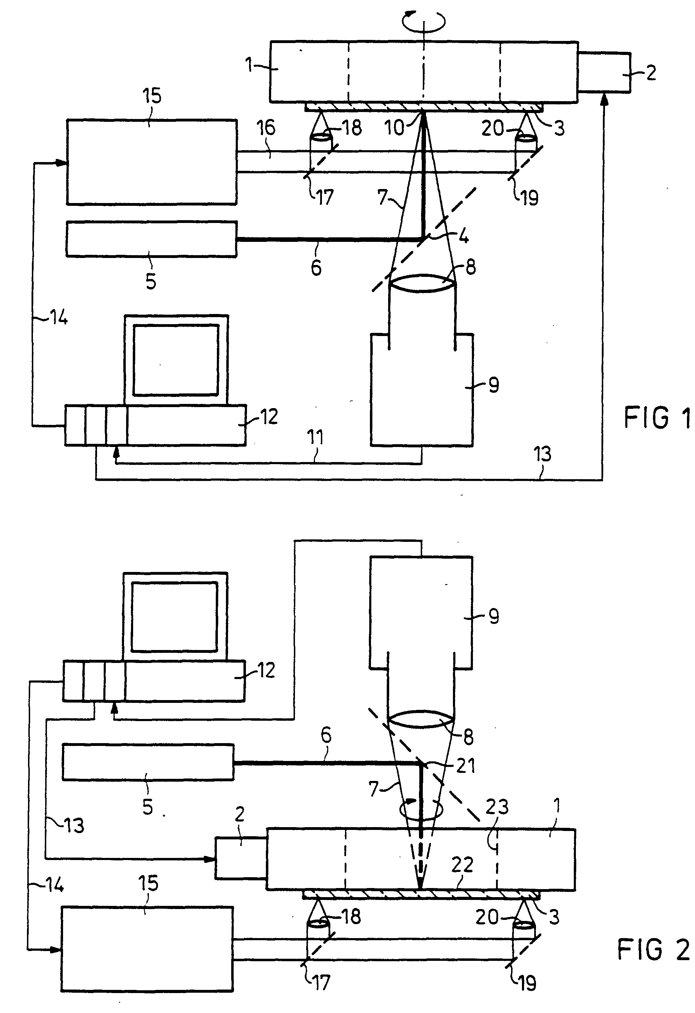

Bei dem Ausführungsbeispiel nach Figur 1 ist an einem nur schematisch dargestellten Drehmeßtisch 1 mit einem ebenfalls nur schematisch dargestellten Antrieb 2 eine zu untersuchende Kristallscheibe 3 gehalten, beispielsweise durch Klammerung bzw. Vakuumhalterung. Dabei wird der Vakuumhalterung der Vorzug gegeben, weil diese eine von mechanischen Spannungen weitgehend freie Halterung ermöglicht. In der Figur 1 unterhalb der Kristallscheibe 3 ist ein halbdurchlässiger Spiegel 4 angeordnet, über den von einem Orientierungslaser 5 abgegebene Strahlung 6 in einem senkrechten Einfallwinkel auf die Kristallscheibe 3 geleitet wird. Die von der Kristallscheibe 3 reflektierte Strahlung 7 wird von einer Sammellinse 8 gesammelt und von einer Videokamera 9 erfaßt.

Ist die Kristallscheibe an einer kleinen Stelle 10 mit einer Lauge, z. B. Kalilauge, aufgerauht, dann ist die Kristallorientierung aus der erzeugten Oberflächenstruktur durch die Symmetrien und die Form des reflektierten Lichts 7 zu finden.

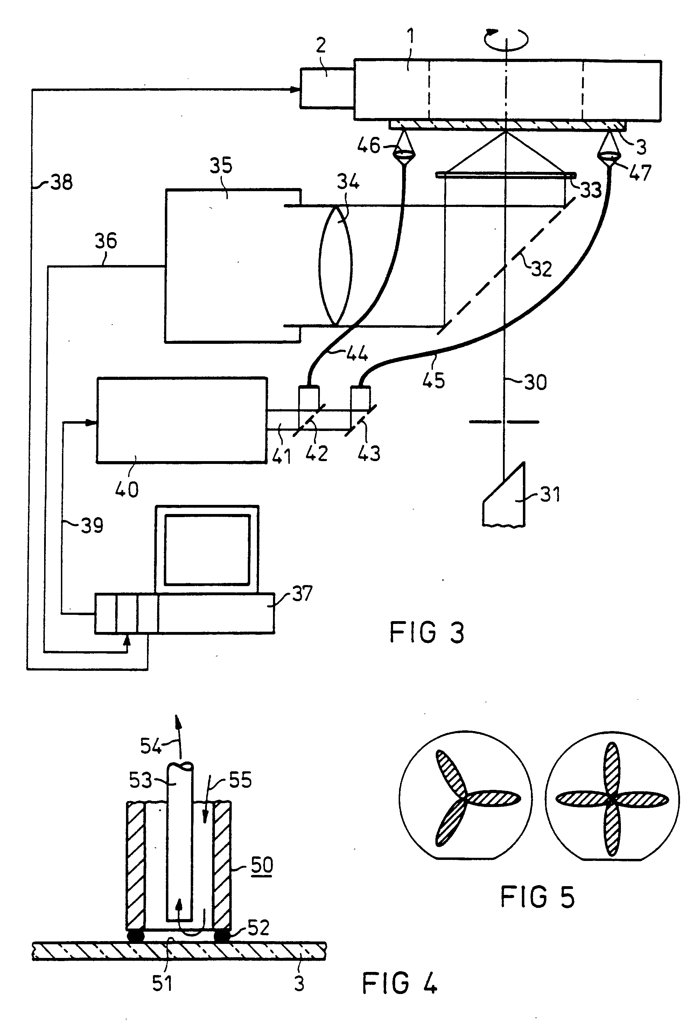

Die Figur 5 zeigt in ihrer linken Darstellung ein solches Reflexionsmuster bei einer Kristallorientierung in der (111)-Ebene; die rechte Darstellung der Figur 5 gibt ein Reflexionsmuster bei einer Kristallorientierung in der (100)-Ebene wieder.

Das von der Videokamera 9 aufgenommene Reflexionsmuster wird in Form entsprechender elektrischer Signale über eine Leitung 11 einem Rechner 12 zugeführt, in dem ein Vergleich mit einem vorgegebenen Reflexionsmuster auf elektronischem Wege erfolgt. Solange die Drehstellung der Kristallscheibe 3 der vom Rechner 12 vorgegebenen Stellung nicht entspricht werden über eine Leitung 13 Betätigungssignale an den Antieb 2 des Drehmeßtisches 1 gegeben.

Ist die vorgegebene bzw. erwünschte Einstellung der Kristallscheibe 3 in Bezug auf die angestrebte Festlegung der Kristallorientierung erreicht, dann wird über eine zusätzliche Verbindungsleitung 14 vom Rechner 12 ein Markierungslaser 15 angeregt, der daraufhin einen Strahlungsimpuls 16 abgibt. Dieser wird über einen halbdurchlässigen Umlenkspiegel 17 einem ersten Markierungselement 18 sowie über einen zweiten Umlenkspiegel 19 einem zweiten Markierungselement 20 zugeführt. Die Markierungselemente 18 und 20 bestehen im dargestellten Ausführungsbeispiel aus jeweils einer Sammellinse, in deren Brennpunkt die Oberfläche der Kristallscheibe 3 liegt; auf der Kristallscheibe 3 entsteht somit eine Markierung, die durch zwei Punkte gekennzeichnet ist, wobei diese beiden Punkte die Ausrichtung der Kristallscheibe 3 in beispielsweise der (110)-Ebene des Kristallgitters angeben.

Bei dem Ausführungsbeispiel nach Figur 2 ist die Markierungseinrichtung mit dem Markierungslaser 15, den Umlenkspiegeln 17 und 19 und den Markierungselementen 18 und 20 in derselben Weise in bezug auf die Kristallscheibe 3 gehalten, wie dies bereits im Zusammenhang mit Figur 1 erläutert worden ist. Anders als bei der Anordnung nach Figur 1 erfolgt bei der Ausführungsform nach Figur 2 die Zuführung der Strahlung 6 des Orientierungslasers 5 über einen in der Figur 2 oberhalb der Kristallscheibe 3 bzw. des Drehmeßtisches 1 befindlichen halbdurchlässigen Spiegels 21, über den die Strahlung 6 des Orientierungslasers 5 von oben auf die von der Markierungseinrichtung abgewandte Seite 22 der zu untersuchenden Kristallscheibe 3 gelenkt wird. Dies ist dadurch möglich, daß der Meßtisch 1 eine Durchgangsöffnung 23 aufweist. Die von der Kristallscheibe 3 reflektierte Strahlung 7 wird wiederum von einer Sammellinse 8 erfaßt und in der nachgeordneten Videokamera 9 in elektrische Signale umgesetzt, die - wie im Zusammenhang mit der Figur 1 beschrieben - in dem Rechner 12 ausgewertet werden. Dieser ist wiederum über die Leitung 13 mit dem Antrieb 2 des Drehmeßtisches 1 verbunden sowie über eine weitere Leitung 14 mit dem Markierungslaser 15. Die Durchführung des erfindungsgemäßen Verfahrens erfolgt mit der Anordnung nach Figur 2 ansonsten in derselben Weise, wie es im Zusammenhang mit der Figur 1 oben erläutert worden ist.

Bei dem Ausführungsbeispiel nach Figur 3 erfolgt die Bestrahlung einer zu untersuchtenden Kristallscheibe 3 mit Röntgenstrahlung 30 aus einer Röntgenröhre 31, die in der Figur nur schematisch angedeutet ist. Im Gang der Strahlung 30 liegt ein halbdurchlässiger Spiegel 32, dem ein Leuchtschirm 33 nachgeordnet ist. Das durch den Spiegel 32 und den Leuchtschirm 33 auf die Kristallscheibe 3 fallende Röntgenstrahlung wird am Kristallgitter gebeugt, und es wird auf dem Leuchtschirm 33 entsprechend z. B. dem bekannten Laue-Verfahren ein Bild erzeugt das charakteristisch für die Orientierung des Kristallgitters der Kristallscheibe ist. Dieses Bild wird über eine Sammellinse : von einer nachgeordneten Videokamera 35 erfaßt, die über eine Leitung 36 entsprechende elektrische Signale an einen Rechner 37 gibt. In diesem findet eine Auswertung entsprechend einem vorgegebenen Bild auf elektronischem Wege statt. Ist die Lage der Kristallscheibe 3 derart, daß die Orientierung des Kristallgitters einer im Rechner vorgegebenen Orientierung nicht entspricht, dann werden über eine Leitung 38 vom Rechner Betätigungsimpulse an den Antrieb 2 des Drehmeßtisches 1 gegeben. Hat durch die Drehung des Drehmeßtisches 1 die Kristallscheibe 3 hinsichtlich der Orientierung des Kristallgitters die vorgegebene Lage erreicht, dann wird über eine Leitung 39 der Markierungslaser 40 zur Abgabe von Laserstrahlung 41 veranlaßt. Im Gang der Laserstrahlung 41 befinden sich zwei Umlenkspiegel 42 und 43, über die die Strahlung in zwei Lichtleiter 44 und 45 eingespeist wird. Beide Lichtleiter 44 und 45 enden an von Sammellinsen gebildeten Markierungselementen 46 und 47, die in nicht dargestellter Weise räumlich fest einander zugeordnet sind.

In Figur 4 ist ein Stempel 50 dargestellt, wie er zur Erzeugung einer kleinen, rauhen Stelle 51 auf der Kristallscheibe 3 Verwendung finden kann. Der Stempel 50 ist an seiner der Kristallscheibe 3 zugewandten Seite mit einem Dichtungsring 52 versehen, um diesen Bereich dicht nach Außen abzuschließen. Innerhalb des Stempels ist in nicht dargestellter Weise ein Rohr 53 gehalten, das zum Ausleiten in Richtung des Pfeiles 54 einer Lauge dient, die in Richtung des Pfeiles 55 in den Stempel bis zu dessen Boden eingeleitet wird. Durch Anätzen verursacht die Lauge die aufgerauhte Stelle 51.

## Patentansprüche

1. Verfahren zum Anbringen einer die Orientierung des Kristallgitters einer Kristallscheibe (3) angebenden Markierung, bei dem
- die Kristallscheibe (3) mit Röntgenstrahlung (30) beaufschlagt wird,
- von der Kristallscheibe (3) reflektierte Strahlung (7) von einem Detektor (9) zur Feststellung der Orientierung des Kristallgitters erfaßt wird,
- eine Markierungseinrichtung (15 ... 20)und die Kristallscheibe (3) derart zueinander in ihrer Ausrichtung verändert werden, daß die Markierungseinrichtung (15 ... 20) entsprechend der festgestellten Orientierung des Kristallgitters ausgerichtet ist und
- in der ausgerichteten Lage die Markierung an der Kristallscheibe (3) angebracht wird,
**dadurch gekennzeichnet, daß**
- die Kristallscheibe (3) in senkrechter Einfallrichtung mit der Röntgenstrahlung (30) beaufschlagt wird,
- als Detektor eine Videokamera (9) verwendet wird,
- in einem Rechner (12) die elektrischen Ausgangssignale der Videokamera (9) ausgewertet werden,
- durch ausgangsseitige Betätigungssignale des Rechners die Markierungseinrichtung (15 ... 20) un die Kristallscheibe (3) zueinander ausgerichtet werden,
- als Markierungseinrichtung (15 ... 20) eine Einrichtung mit einem Markierungslaser (15) und mit zwei Markierungselementen (18,20) verwendet wird, die in fester räumlicher Anordnung zueinander gehalten sind, und
- in der ausgerichteten Lage auf einer Seite der Kristallscheibe (3) die Markierung angebracht wird.

2. Verfahren zum Anbringen einer die Orientierung des Kristallgitters einer Kristallscheibe (3) angebenden Markierung, bei dem
- die Kristallscheibe (3) mit einer Strahlung (30) beaufschlagt wird,
- von der Kristallscheibe (3) reflektierte Strahlung (7) von einem Detektor (9) zur Feststellung der Orientierung des Kristallgitters erfaßt wird,
- eine Markierungseinrichtung (15 ... 20) und die Kristallscheibe (3) derart zueinander in ihrer Ausrichtung verändert werden, daß die Markierungseinrichtung (15 ... 20) entsprechend der festgestellten Orientierung des Kristallgitters ausgerichtet ist und
- in der ausgerichteten Lage die Markierung an der Kristallscheibe (3) angebracht wird,
**dadurch gekennzeichnet , daß**
- die Kristallscheibe (3) in senkrechter Einfallrichtung an einer aufgerauhten, kleinen Stelle (10) mit der Strahlung (6) eines Orientierungslasers (5) beaufschlagt wird,
- als Detektor eine Videokamera (9) verwendet wird,
- in einem Rechner (12) die elektrischen Ausgangssignale der Videokamera (9) ausgewertet werden,
- durch ausgangsseitige Betätigungssignale des Rechners die Markierungseinrichtung (15 ... 20) und die Kristallscheibe (3) zueinander ausgerichtet werden,
- als Markierungseinrichtung (15 ... 20) eine Einrichtung mit einem Markierungslaser (15) und mit zwei Markierungselementen (18,20) verwendet wird, die in fester räumlicher Anordnung zueinander gehalten sind, und
- in der ausgerichteten Lage auf einer Seite der Kristallscheibe (3) die Markierung angebracht wird.

3. Verfahren nach Anspruch 1 oder 2,
**dadurch gekennzeichnet, daß**
ein und dieselbe Seite der Kristallscheibe (3) mit der Röntgenstrahlung(30) oder der Strahlung (6) des Orientierungslasers (5) beaufschlagt sowie mit der Markierung versehen wird.

4. Verfahren nach Anspruch 1 oder 2,
**dadurch gekennzeichnet, daß**
eine Seite (22) der Kristallscheibe (3) mit der Röntgenstrahlung oder der Strahlung (6) des Orientierungslasers (5) beaufschlagt wird und auf die andere Seite der Kristallscheibe (3) die Markierung aufgebracht wird.

5. Verfahren nach einem der vorangehenden Ansprüche,
**dadurch gekennzeichnet, daß**
daß die aufgerauhte, kleine Stelle (10) auf der Kristallscheibe (3) durch Ätzen mit einer Lauge erzielt wird.

6. Verfahren nach Anspruch 5,
**dadurch gekennzeichnet, daß**
zur Begrenzung der kleinen Stelle (10) lithografisch eine Ätzmaskierung erfolgt oder ein nach außen abgedichteter Stempel (50) mit innerer Zu- und Abführung der Lauge verwendet wird.

7. Verfahren nach einem der vorangehenden Ansprüche,
**dadurch gekennzeichnet, daß**
die Ausrichtung von Markierungseinrichtung (15 ... 20) und Kristallscheibe (3) zueinander durch Drehen der Kristallscheibe (3) um eine senkrecht zu ihr verlaufende Achse vorgenommen wird.

8. Verfahren nach einem der vorangehenden Ansprüche,
**dadurch gekennzeichnet, daß**
die Röntgenstrahlung (30) oder die Strahlung (6) des Orientierungslasers (5) über einen halbdurchlassigen Spiegel (4) der Kristallscheibe (3) zugeführt wird und daß die reflektierte Strahlung (7) über enselben Spiegel (4) der Videokamera (9) zugeleitet wird.

9. Verfahren nach einem der vorangehenden Ansprüche,
**dadurch gekennzeichnet, daß**
von dem Rechner (12) aus den Ausgangssignalen der Videokamera (9) die Kristallgitter-Orientierung zur Oberflächennormale der Kristallscheibe (Azimut) bestimmt wird und daß zur doppelseitigen Bearbeitung der Kristallscheibe (3) zu der Markierung auf der einen Seite der Kristallscheibe (3) eine weitere Markierung auf der anderen Seite der Kristallscheibe (3) derart aufgebracht wird, daß die weitere Markierung unter Berücksichtigung der Dicke der Kristallscheibe (3) dem Azimut entsprechend versetzt ist.

10. Anordnung zum Anbringen einer die Orientierung des Kristallgitters einer Kristallscheibe (3) angebenden Markierung mit
- einer derart angeordneten Quelle für Röntgen- oder Laserstrahlung, daß eine senkrechte Einfallrichtung der Strahlung auf die Kristallscheibe (3) ermöglicht ist,
- einer Halterung (1) für die Kristallscheibe(3),
- einem Detektor in Form einer Videokamera(9)zum Erfassen der von der Kristallscheibe (3) reflektierten Strahlung,
- Mitteln zum Ausrichten der Kristallscheibe (3) und einer Markierungseinrichtung (15...20) gegeneinander, um in der ausgerichteten Lage Markierungen auf der Kristallscheibe (3) anzubringen,
- wobei die Markierungseinrichtung einen Markierungslaser (15) und zwei in fester räumlicher Zuordnung zueinander gehaltene Markierungselemente (18,20) umfaßt, und
- einem Rechner (12) zum Auswerten der Steuersignale des Detektors (9) und zum Steuern der Ausrichtung der Kristallscheibe (3) und der Markierungseinrichtung (15...20) gegeneinander.

11. Anordnung nach Anspruch 10,
**dadurch gekennzeichnet, daß**
- die Halterung ein Drehmeßtisch (1) ist und
- der vom Drehmeßtisch (1) abgewandten Seite der Kristallscheibe (3) gegenüber die zwei Markierungselemente (18, 20) der Markierungseinrichtung (15 ...20) angeordnet sind.

12. Anordnung nach Anspruch 10 oder 11,
**dadurch gekennzeichnet, daß**
- die zwei Markierungselemente aus jeweils einer optischen Sammeleinrichtung (18, 20) bestehen.

13. Anordnung nach Anspruch 12,
**dadurch gekennzeichnet, daß**
den optischen Sammeleinrichtungen (46, 47) die Strahlung (41) des Markierungslasers (40) über jeweils einen Lichtleiter (44, 45) zugerührt ist.

14. Anordnung nach Anspruch 12,
**dadurch gekennzeichnet, daß**
daß den optischen Sammeleinrichtungen (18, 20) die Strahlung (16) des Markierungslasers (15) über fluchtend zum Ausgang des Markierungslasers (15) angeordnete Umlenkspiegel (17,19) zugeführt ist.

15. Anordnung nach einem der Ansprüche 10 bis 14,
**dadurch gekennzeichnet, daß**
bei einer Beaufschlagung mit Röntgenstrahlung (30) zwischen dem halbdurchlässigen Spiegel (32) und der Kristallscheibe (3) ein Leuchtschirm (33) liegt.

## Claims

1. Method for providing a marker indicating the orientation of the crystal lattice of a crystal wafer (3), in which
- X-ray radiation (30) is applied to the crystal wafer (3),
- radiation (7) reflected from the crystal wafer (3) is detected by a detector (9) for ascertaining the orientation of the crystal lattice,
- a marking device (15 ... 20) and the crystal wafer (3) are altered in their orientation relative to one another in such a way that the marking device (15 ... 20) is oriented in accordance with the ascertained orientation of the crystal lattice, and
- the marker is provided on the crystal wafer (3) in the oriented position,
**characterized in that**
- the X-ray radiation (30) is applied to the crystal wafer (3) in a perpendicular direction of incidence,
- a video camera (9) is used as the detector,
- the electrical output signals of the video camera (9) are evaluated in a computer (12),
- the marking device (15 ... 20) and the crystal wafer (3) are oriented relative to one another by means of output-side actuation signals of the computer,
- the marking device (15 ... 20) is a device having a marking laser (15) and having two marking elements (18, 20), which are held in a fixed spatial arrangement relative to one another, and
- the marker is provided on one side of the crystal wafer (3) in the oriented position.

2. Method for providing a marker indicating the orientation of the crystal lattice of a crystal wafer (3), in which
- radiation (30) is applied to the crystal wafer (3),
- radiation (7) reflected from the crystal wafer (3) is detected by a detector (9) for ascertaining the orientation of the crystal lattice,
- a marking device (15 ... 20) and the crystal wafer (3) are altered in their orientation relative to one another in such a way that the marking device (15 ... 20) is oriented in accordance with the ascertained orientation of the crystal lattice, and
- the marker is provided on the crystal wafer (3) in the oriented position,
**characterized in that**
- the radiation (6) of an orientation laser (5) is applied to the crystal wafer (3) in a perpendicular direction of incidence at a roughened, small location (10),
- a video camera (9) is used as the detector,
- the electrical output signals of the video camera (9) are evaluated in a computer (12),
- the marking device (15 ... 20) and the crystal wafer (3) are oriented relative to one another by means of output-side actuation signals of the computer,
- the marking device (15 ... 20) is a device having a marking laser (15) and having two marking elements (18, 20), which are held in a fixed spatial arrangement relative to one another, and
- the marker is provided on one side of the crystal wafer (3) in the oriented position.

3. Method according to Claim 1 or 2,
**characterized in that**
the X-ray radiation (30) or the radiation (6) of the orientation laser (5) is applied to one and the same side of the crystal wafer (3), which side is also provided with the marker.

4. Method according to Claim 1 or 2,
**characterized in that**
the X-ray radiation or the radiation (6) of the orientation laser (5) is applied to one side (22) of the crystal wafer (3) and the marker is applied to the other side of the crystal wafer (3).

5. Method according to one of the preceding claims,
**characterized in that**
the roughened, small location (10) on the crystal wafer (3) is obtained by etching with an alkaline solution.

6. Method according to Claim 5,
**characterized in that**
in order to delimit the small location (10), etching masking is effected lithographically or use is made of an outwardly sealed plunger (50) with internal supply and discharge of the alkaline solution.

7. Method according to one of the preceding claims,
**characterized in that**
the orientation of marking device (15 ... 20) and crystal wafer (3) relative to one another is performed by rotating the crystal wafer (3) about an axis running perpendicular to it.

8. Method according to one of the preceding claims,
**characterized in that**
the X-ray radiation (30) or the radiation (6) of the orientation laser (5) is supplied to the crystal wafer (3) via a semitransparent mirror (4), and **in that** the reflected radiation (7) is forwarded to the video camera (9) via the same mirror (4).

9. Method according to one of the preceding claims,
**characterized in that**
the crystal lattice orientation with respect to the normal to the surface of the crystal wafer (azimuth) is determined from the output signals of the video camera (9) by the computer (12), and **in that**, for double-sided processing of the crystal wafer (3), with respect to the marker on one side of the crystal wafer (3), a further marker is applied on the other side of the crystal wafer (3) in such a way that the further marker is offset in accordance with the azimuth taking account of the thickness of the crystal wafer (3).

10. Arrangement for providing a marker indicating the orientation of the crystal lattice of a crystal wafer (3), having
- a source for X-ray or laser radiation which is arranged in such a way as to enable a perpendicular direction of incidence of the radiation on the crystal wafer (3),
- a mount (1) for the crystal wafer (3),
- a detector in the form of a video camera (9) for detecting the radiation reflected from the crystal wafer (3),
- means for orienting the crystal wafer (3) and a marking device (15 ... 20) relative to one another, in order to provide markers on the crystal wafer (3) in the oriented position,
- the marking device comprising a marking laser (15) and two marking elements (18, 20), which are held in a fixed spatial assignment with respect to one another, and
- a computer (12) for evaluating the control signals of the detector (9) and for controlling the orientation of the crystal wafer (3) and of the marking device (15 ... 20) relative to one another.

11. Arrangement according to Claim 10,
**characterized in that**
- the mount is a rotating measurement table (1), and
- the two marking elements (18, 20) of the marking device (15 ... 20) are arranged opposite that side of the crystal wafer (3) which is remote from the rotating measurement table (1).

12. Arrangement according to Claim 10 or 11,
**characterized in that**
- the two marking elements each comprise an optical collecting device (18, 20).

13. Arrangement according to Claim 12,
**characterized in that**
the radiation (41) of the marking laser (40) is supplied to the optical collecting devices (46, 47) via a respective optical waveguide (44, 45).

14. Arrangement according to Claim 12,
**characterized in that**
the radiation (16) of the marking laser (15) is supplied to the optical collecting devices (18, 20) via deflection mirrors (17, 19) arranged in a manner aligned with the output of the marking laser (15).

15. Arrangement according to one of Claims 10 to 14,
**characterized in that**
in the case of the application of X-ray radiation (30), a fluorescent screen (33) is located between the semitransparent mirror (32) and the crystal wafer (3).

## Revendications

1. Procédé pour appliquer un repère indiquant l'orientation du réseau cristallin d'une tranche cristalline (3), dans lequel
- on soumet la tranche cristalline (3) à un rayonnement X (30),
- on détecte au moyen d'un détecteur (9) le rayonnement (7) réfléchi par la tranche cristalline (3) afin de déterminer l'orientation du réseau cristallin,
- on modifie l'orientation d'un dispositif de repérage (15 à 20) et de la tranche cristalline (3) l'un par rapport à l'autre de telle sorte que le dispositif de repérage (15 à 20) est orienté selon l'orientation déterminée du réseau cristallin, et
- dans la position orientée, on applique le repère sur la tranche cristalline (3),
**caractérisé par le fait que**
- on soumet la tranche cristalline (3) au rayonnement X (30) selon une direction d'incidence perpendiculaire,
- comme détecteur, on utilise une caméra vidéo (9),
- dans un ordinateur (12), on exploite les signaux de sortie électriques de la caméra vidéo (9),
- par des signaux d'actionnement côté sortie de l'ordinateur, on oriente le dispositif de repérage (15 à 20) et la tranche cristalline (3) l'un par rapport à l'autre,
- comme dispositif de repérage (15 à 20), on utilise un dispositif comportant un laser de repérage (15) et deux éléments de repérage (18, 20) qui sont maintenus dans un agencement mutuel fixe dans l'espace, et
- dans la position orientée, on applique le repère sur un côté de la tranche cristalline (3).

2. Procédé pour appliquer un repère indiquant l'orientation du réseau cristallin d'une tranche cristalline (3), dans lequel
- on soumet la tranche cristalline (3) à un rayonnement (30),
- on détecte au moyen d'un détecteur (9) le rayonnement (7) réfléchi par la tranche cristalline (3) afin de déterminer l'orientation du réseau cristallin,
- on modifie l'orientation d'un dispositif de repérage (15 à 20) et de la tranche cristalline (3) l'un par rapport à l'autre de telle sorte que le dispositif de repérage (15 à 20) est orienté selon l'orientation déterminée du réseau cristallin, et
- dans la position orientée, on applique le repère sur la tranche cristalline (3),
**caractérisé par le fait que**
- on soumet la tranche cristalline (3) au rayonnement (6) d'un laser d'orientation (5) selon une direction d'incidence perpendiculaire sur une petite zone rugueuse (10),
- comme détecteur, on utilise une caméra vidéo (9),
- dans un ordinateur (12), on exploite les signaux de sortie électriques de la caméra vidéo (9),
- par des signaux d'actionnement côté sortie de l'ordinateur, on oriente le dispositif de repérage (15 à 20) et la tranche cristalline (3) l'un par rapport à l'autre,
- comme dispositif de repérage (15 à 20), on utilise un dispositif comportant un laser de repérage (15) et deux éléments de repérage (18, 20) qui sont maintenus dans un agencement mutuel fixe dans l'espace, et
- dans la position orientée, on applique le repère sur un côté de la tranche cristalline (3).

3. Procédé selon la revendication 1 ou 2,
**caractérisé par le fait qu'**on soumet un seul et même côté de la tranche cristalline (3) au rayonnement X (30) ou au rayonnement (6) du laser d'orientation (5) et on le munit du repère.

4. Procédé selon la revendication 1 ou 2,
**caractérisé par le fait qu'**on soumet un côté (22) de la tranche cristalline (3) au rayonnement X ou au rayonnement (6) du laser d'orientation (5) et on applique le repère sur l'autre côté de la tranche cristalline (3).

5. Procédé selon l'une des revendications précédentes,
**caractérisé par le fait qu'**on obtient la petite zone rugueuse (10) sur la tranche cristalline (3) par gravure avec une soude caustique.

6. Procédé selon la revendication 5,
**caractérisé par le fait que**, pour limiter la petite zone (10), on effectue un masquage de gravure de façon lithographique ou on utilise un poinçon (50) étanche face à l'extérieur et muni d'une alimentation intérieure et d'une évacuation intérieure pour la soude caustique.

7. Procédé selon l'une des revendications précédentes,
**caractérisé par le fait qu'**on met en oeuvre l'orientation du dispositif de repérage (15 à 20) et de la tranche cristalline (3) l'un par rapport à l'autre par une rotation de la tranche cristalline (3) autour d'un axe perpendiculaire à elle.

8. Procédé selon l'une des revendications précédentes,
**caractérisé par le fait qu'**on envoie le rayonnement X (30) ou le rayonnement (6) du laser d'orientation (5) à la tranche cristalline (3) par l'intermédiaire d'un miroir semi-transparent (4) et qu'on conduit le rayonnement réfléchi (7) par l'intermédiaire du même miroir (4) à la caméra vidéo (9).

9. Procédé selon l'une des revendications précédentes,
**caractérisé par le fait qu'**on détermine au moyen de l'ordinateur (12) à partir des signaux de sortie de la caméra vidéo (9) l'orientation du réseau cristallin par rapport à la normale à la surface de la tranche cristalline (azimut) et qu'on applique en plus du repère sur un côté de la tranche cristalline (3) un autre repère sur l'autre côté de la tranche cristalline (3) en vue du traitement des deux côtés de la tranche cristalline (3) de telle sorte que l'autre repère est décalé en fonction de l'azimut en tenant compte de l'épaisseur de la tranche cristalline (3).

10. Dispositif pour appliquer un repère indiquant l'orientation du réseau cristallin d'une tranche cristalline (3), comportant
- une source de rayonnement X ou de rayonnement laser agencée de telle sorte qu'une direction d'incidence perpendiculaire du rayonnement sur la tranche cristalline (3) est possible,
- une fixation (1) pour la tranche cristalline (3),
- un détecteur sous la forme d'une caméra vidéo (9) pour la détection du rayonnement réfléchi par la tranche cristalline (3),
- des moyens pour l'orientation de la tranche cristalline (3) et d'un dispositif de repérage (15 à 20) l'un par rapport à l'autre afin d'appliquer des repères sur la tranche cristalline (3) dans la position orientée,
- le dispositif de repérage comprenant un laser de repérage (15) et deux éléments de repérage (18, 20) maintenus dans un agencement mutuel fixe dans l'espace, et
- un ordinateur (12) pour l'exploitation des signaux de commande du détecteur (9) et pour la commande de l'orientation de la tranche cristalline (3) et du dispositif de repérage (15 à 20) l'un par rapport à l'autre.

11. Dispositif selon la revendication 10,
**caractérisé par le fait que**
- la fixation est une table de mesure tournante (1), et
- les deux éléments de repérage (18, 20) du dispositif de repérage (15 à 20) sont agencés en face du côté, opposé à la table de mesure tournante (1), de la tranche cristalline (3).

12. Dispositif selon la revendication 10 ou 11,
**caractérisé par le fait que**
- les deux éléments de repérage sont constitués chacun d'un dispositif de convergence optique (18, 20).

13. Dispositif selon la revendication 12,
**caractérisé par le fait que** le rayonnement (41) du laser de repérage (40) est envoyé aux dispositifs de convergence optique (46, 47) par l'intermédiaire d'un guide d'onde lumineuse (44, 45) respectif.

14. Dispositif selon la revendication 12,
**caractérisé par le fait que** le rayonnement (16) du laser de repérage (15) est envoyé aux dispositifs de convergence optique (18, 20) par l'intermédiaire de miroirs de déviation (17, 19) alignés avec la sortie du laser de repérage (15).

15. Dispositif selon l'une des revendications 10 à 14,
**caractérisé par le fait que**, dans le cas d'une exposition à un rayonnement X (30), un écran luminescent (33) se trouve entre le miroir semi-transparent (32) et la tranche cristalline (3).
